# EUROPÄISCHE PATENTSCHRIFT

(11) **EP 1 072 179 B1**
(45) Veröffentlichungstag und Bekanntmachung des Hinweises auf die Patenterteilung: **02.01.2002**
(21) Anmeldenummer: 99920674.1
(22) Anmeldetag: 15.04.1999
(51) Int. Cl.: H05K 7/14

(54) **BAUGRUPPENTRÄGER**
SUBRACK
SUPPORT DE MODULES

(30) Priorität: 17.04.1998 DE 19817089
(43) Veröffentlichungstag der Anmeldung: 31.01.2001
(73) Patentinhaber: Schroff GmbH, D-75334 Straubenhardt (DE)
(72) Erfinder: HAAG, Volker, D-75323 Bad Wildbad (DE); JOIST, Michael, D-76571 Gaggenau (DE); KERN, Klaus, D-75334 Straubenhardt (DE); MAZURA, Paul, D-76307 Karlsbad (DE)
(74) Vertreter: Durm, Klaus, Dr.-Ing.
(86) Internationale Anmeldenummer: EP9902529
(87) Internationale Veröffentlichungsnummer: WO9955129

(56) Entgegenhaltungen:
- DE-A- 3 140 730
- DE-A- 19 523 964
- US-A- 4 277 120
- US-A- 5 313 370

## Beschreibung

Die Erfindung betrifft einen Baugruppenträger mit zwei Seitenwänden, mit wenigstens einem Deckblech sowie mit wenigstens einem Bodenblech, wobei das Deckblech und das Bodenblech zwischen den Seitenwänden befestigt sind und das Deckblech sowie das Bodenblech eine rechtwinkelig hochstehende Abkantung aufweisen.

Baugruppenträger, wie sie zur Aufnahme von einsteckbaren, mit elektrischen und elektronischen Bauelementen bestückten Baugruppen dienen, sind in der Industrieelektronik seit langem bekannt.

In einfachster Ausführung besteht ein solcher Baugruppenträger aus zwei Seitenwänden und vier Modulschienen, welche mit ihren beiderseitigen Stirnflächen an den Innenflächen der aus Aluminium bestehenden, ausgestanzten Seitenwänden angeschraubt sind. Ein Deckblech und ein Bodenblech sowie eine Rückwand können den Baugruppenträger zu einem geschlossenen Gehäuse werden lassen, von dessen offener Frontseite her die Baugruppen auf eingesetzten Führungsschienen eingeschoben werden. Die Baugruppen weisen Teilfrontplatten auf, die an die beiden vorderen Modulschienen angelehnt und oben und unten angeschraubt sind. Ein- und Ausziehvorrichtungen, die mit den Modulschienen in Verbindung treten, vervollständigen den Baugruppenträger.

Die für Baugruppenträger benötigten Modulschienen weisen - um allen Anforderungen der Befestigung der Teilfrontplatten und der Führungsschienen zu genügen - mehr oder weniger aufwendig gestaltete Profile auf, sie bestehen daher aus stranggepreßtem Aluminium. Zur Herstellung dieser Modulschienen werden komplizierte Werkzeuge benötigt, deren Fertigung ist somit teuer. Versuche, die Modulschienen durch mehrfache Abkantungen von Streifen aus Stahlblech herzustellen, sind bisher gescheitert, weil die unumgänglichen, großen Biegeradien die benötigten scharfkantigen Übergänge benachbarter Flächen nicht zulassen. Hier greift die Erfindung ein.

Es ist zwar ein Gehäuse zur Aufnahme von Steckbaugruppen bekannt (US-PS 4 277 120), welches zwei Seitenwände, ein Deckblech und ein Bodenblech aufweist, wobei das Deckblech eine rechtwinkelig hochstehende Abkantung trägt, welche zur Befestigung einer niederen U-Schiene zum Einschieben von Beschriftungsstreifen dient.

Bei einem anderen, bekannten Baugruppenträger sind zur Verbindung der Seitenwände Modulschienen vorgesehen, die jeweils aus zwei verschieden breiten U-Schienen zusammengesetzt sind, welche ineinander liegen. Zu ihrer Verbindung dienen an der inneren Schiene hervorstehende Blechnasen, die in Schlitze im Steg der äußeren, breiteren U-Schiene eingreifen (DE-OS 195 23 964).

Ein bekannter, kostengünstig herstellbarer Baugruppenträger besitzt zwei Seitenwände, die mit dem Deckenteil und dem Bodenteil zusammensteckbar sind. Hierzu tragen die Seiten mäanderförmige Kantenausstanzungen, deren Finger in trapezförmige, ausgestanzte Ausbuchtungen eingreifen, die an nach innen vorstehenden Abkantungen von Decke und Boden vorgesehen sind (DE 295 02 404); Front- und rückseitige Querholme sind durch Mehrfachabbiegungen vom Boden- und Deckenteil gebildet.

Die Aufgabe der Erfindung besteht in der Konzeption eines besonders preiswert herstellbaren Baugruppenträgers.

Zur Lösung der Aufgabe wird von einem wie eingangs beschriebenen, bekannten Baugruppenträger ausgegangen, wobei sie durch folgende, konstruktive Maßnahmen gelöst wird, nämlich: Je eine Winkelleiste ist am Deckblech bzw. am Bodenblech parallel zu der Abkantung angesetzt, die Winkelleiste besitzt einen breiten Schenkel und einen rechtwinkelig abgekanteten, schmalen Schenkel, der schmale Schenkel trägt eine Reihe von Gewindelöchern, die Abkantung steht mit ihrer Längskante auf der Innenseite des breiten Schenkels auf, der schmale Schenkel steht mit seiner Außenkante auf der Außenseite des Deckbleches bzw. des Bodenbleches, die Abkantung weist eine Reihe von Löchern auf, die mit den Gewindelöchern fluchten, und entlang der Längskante der Abkantung und der Außenkante sind Verbindungsmittel vorgesehen.

Mehrere parallele Reihen von rechteckigen und kreisförmigen Löchern und Öffnungen sind zur Aufnahme der Befestigungsmittel einsteckbarer Führungsschienen vorgesehen.

Bei dem vorgeschlagenen Baugruppenträger gibt es keine getrennten Modulschienen mehr, diese sind vielmehr integrierte Bestandteile des Deckbleches und des Bodenbleches. Die Herstellung der konzipierten, zur Befestigung an den Vorderkanten bzw. den Hinterkanten von Deckblech und Bodenblech vorgesehenen Winkelleiste läßt sich problemlos im Rahmen der Stahlblechverarbeitung durch Abschneiden, Abkanten und Lochstanzen herstellen. Das gleiche gilt für die dazugehörige Ausbildung der Abkantung des Deckbleches und des Bodenbleches. Die Stoßkante zwischen der Abkantung des Deckbleches bzw. des Bodenbleches und dem breiten Schenkel der Winkelleiste ist scharfkantig, was eine einwandfreie Befestigung der Teilfrontplatten der eingesetzten Baugruppen ermöglicht. Gegenüber stranggepreßten Aluminiumprofilen für getrennte Modulschienen ergibt sich eine entscheidende Vereinfachung und Verbilligung der wesentlichen Teile eines Baugruppenträgers.

Zweckmäßig bestehen das Deckblech, das Bodenblech sowie die Winkelleiste aus korrosionsgeschütztem Stahlblech gleicher Dicke. Dies dient der Vereinfachung der Fertigung.

Wenigstens ein Teil der Löcher der Abkantung ist als Paßlöcher ausgebildet. In diese greifen Positionierstifte ein, die an der Rückseite der Teilfrontplatten hervorstehen.

Vorteilhaft bildet der breite Schenkel der Winkelleiste einen vorstehenden Überstand, in welchem äquidistante Rechtecköffnungen in Reihe vorgesehen sind. Dieser Überstand (üblicherweise mit "Dach" bezeichnet) dient zusammen mit den Rechtecköffnungen den an den Baugruppen vorgesehenen Ein- und Ausziehvorrichtungen als Widerlager.

Nach einem wichtigen Merkmal der Ausgestaltung der Erfindung stehen als Verbindungsmittel entlang der Außenkante des schmalen Schenkels eine erste Reihe von Zinken hervor, die in eine erste Reihe von Aufnahmen im Deckblech bzw. Bodenblech eingreifen.

Zusätzlich kann zur Erhöhung der Festigkeit der Verbindung der Winkelschiene mit dem Deckblech bzw. Bodenblech als Verbindungsmittel entlang der Abkantung des Deckbleches und des Bodenbleches eine zweite Reihe von Zinken hervorstehen, die in eine zweite Reihe von Aufnahmen im breiten Schenkel der Winkelleiste eingreifen.

Vorteilhaft ist die Reihe der Zinken gegenüber der Reihe von Aufnahmen jeweils in sich geringfügig versetzt angeordnet, so daß beim Zusammenfügen der Teile eine gute, zuverlässige Klemmverbindung erzielt wird.

Durch Niederdrücken der Oberseite der in den Aufnahmen sitzenden Zinken mittels eines Werkzeuges wie bei einem Nietvorgang kann die Festigkeit der Verbindung noch gesteigert werden.

An die Stelle der Verbindung mittels in die Aufnahme eingreifender Zinken kann als Verbindungsmittel auch alleine ein Kleber vorgesehen sein. Dieser erübrigt die Herstellung von Zinken und Aufnahmen beim Stanzen der zu verbindenden Bauelemente, so daß zusätzlich Kosten reduziert werden können. Zur Verbindung kann entlang der Außenkante des schmalen Schenkels und der Abkantung von Deck- und Bodenblech auch jede andere bekannte Befestigungsmethode eingesetzt werden.

Zweckmäßig weisen das Deckblech und das Bodenblech an ihren Seitenrändern rechtwinklig hochstehende Laschen auf, die mit Befestigungslöchern versehen sind, welche mit Schraubenlöchern an den Längsrändern der Seitenwände fluchten. Damit wird auf einfache Weise die Befestigung von Deck- und Bodenblech an den Seiten des Baugruppenträgers ermöglicht.

Eine weitere, erhebliche Einsparung kann dadurch erreicht werden, wenn das Deckblech und das Bodenblech identisch ausgebildet sind.

Zwischen der Abkantung und dem schmalen Schenkel kann ein Abstand vorgesehen sein, wodurch zwischen dem Deckblech bzw. dem Bodenblech und der Winkelleiste ein geschlossener Kanal von rechteckigem Querschnitt gebildet wird. Dies erhöht die Biegesteifigkeit der mit den Winkelleisten versehenen Vorderkanten von Deckblech und Bodenblech beträchtlich. Deren hintere Kanten sind mit einer weiteren Abkantung versehen.

Nach einem weiteren, erfindungserheblichen Merkmal weisen das Deckenteil und das Bodenteil an ihrer Hinterkante eine weitere Winkelleiste sowie eine Ausbildung auf, welche mit derjenigen ihrer vorderen Stirnseite übereinstimmen.

Besonders vorteilhaft ist es, wenn das Deckblech mit dem Deckenteil und das Bodenblech mit dem Bodenteil einstückig gefertig sind und Deckenteil sowie Bodenteil an ihrer hinteren Kante eine weitere Winkelleiste sowie eine Ausbildung aufweisen, welche mit derjenigen der vorderen Stirnseite übereinstimmt.

Die Erfindung wird nachfolgend anhand der beigefügten Zeichnungen näher erläutert. Dabei zeigen
- Fig. 1: einen erfindungsgemäßen Baugruppenträger, in einer schmalen Ausführungsform, in perspektivischer Darstellung, in etwa auf die Hälfte verkleinertem Maßstab;
- Fig. 2: ein einstückiges Bodenblech des Baugruppenträgers nach Fig. 1;
- Fig. 3: ein Bodenblech nach Fig. 2 und eine zugehörige Winkelleiste, explosionsartig auseinandergezogen;
- Fig. 4: eine vordere Ecke des Bodenbleches nach Fig. 2 und der Winkelleiste in einem vergrößerten Ausschnitt gemäß "A" der Fig. 3.

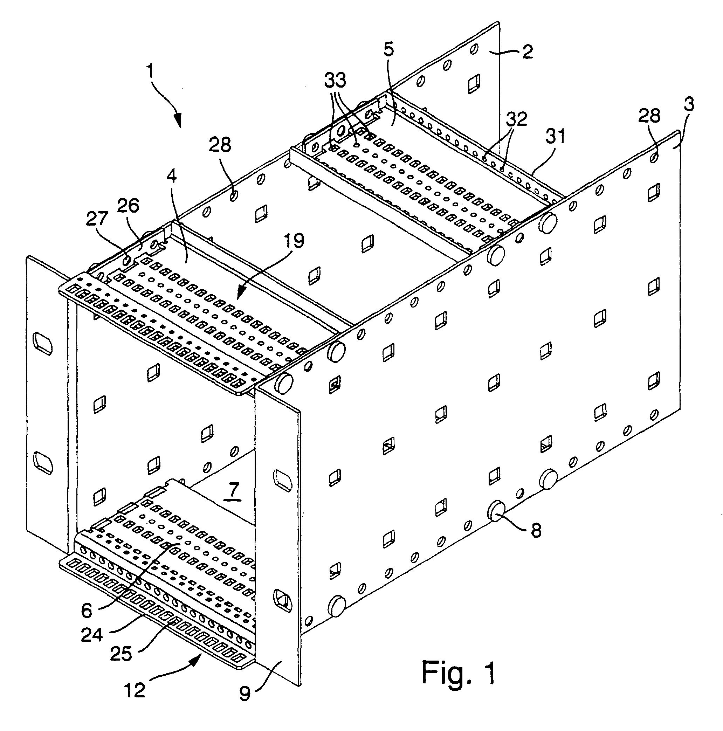

Der in Figur 1 dargestellte Baugruppenträger 1 ist aus zwei parallelen Seitenwänden 2 und 3, einem Deckblech 4 und einem Deckenteil 5 sowie einem Bodenblech 6 und einem (nicht sichtbaren) Bodenteil 7 zusammengesetzt. Alle Teile bestehen aus korrosionsgeschütztem Stahlblech mit einer gleichen Dicke von etwa eineinhalb Millimeter.

Das Deckblech 4, das Deckenteil 5, das Bodenblech 6 und das Bodenteil 7 sitzen zwischen den beiden Seitenwänden 2 und 3 und sind dort mit Hilfe von Kopfschrauben 8 befestigt. Die Decke und der Boden des Baugruppenträgers 1 sind somit jeweils zweiteilig ausgebildet. Diese vier Bauelemente sind jeweils identisch ausgebildet. Zur Halterung an einem (nicht dargestellten) Gestell dienen an der Stirnseite der Seitenwände 2 und 3 abgebogene Befestigungsflansche 9.

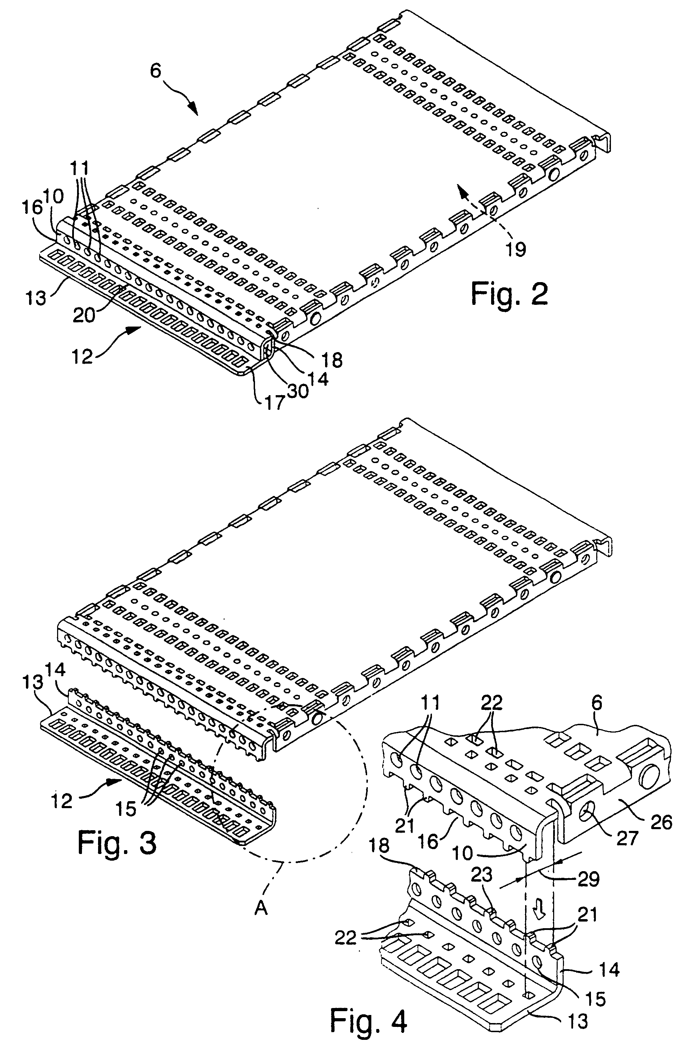

Sowohl das Deckblech 4 wie das Bodenblech 6 sind an ihren vorderen Stirnseiten mit einer schmalen Abkantung 10 versehen - vergleiche Fig. 2-, die rechtwinklig aus der Ebene von Deckblech 4 und Bodenblech 6 hochstehen. Diese Abkantung weist eine Reihe von äquidistanten Löchern 11 auf.

In den Figuren 2 bis 4 ist eine Ausführungsform wiedergegeben, bei welcher das Bodenblech 6 mit dem Bodenteil 7 ein gemeinsames, einstückiges Bauteil für den Boden des Baugruppenträgers 1 bilden. Auch die Decke kann solchermaßen ausgestaltet sein.

Am Deckblech 4 und am Bodenblech 6 ist jeweils eine Winkelleiste 12 angesetzt, die parallel zur betreffenden Abkantung 10 liegt. Diese aus Stahlblech bestehende, lange Winkelleiste 12 besitzt einen breiten Schenkel 13 und einen schmalen Schenkel 14, der rechtwinklig abgekantet ist. Die Winkelleiste 12 erstreckt sich über die gesamte Breite des Deckbleches 4 bzw. des Bodenbleches 6 - siehe Figur 3. Dabei trägt der schmale Schenkel 14 eine Reihe von Gewindelöchern 15, die mit den Löchern 11 der Abkantung 10 fluchten.

Die Winkelleiste 12 ist so angeordnet, daß die Abkantung 10 des Deckbleches 4 bzw. des Bodenbleches 6 mit ihrer Längskante 16 auf der Innenseite 17 des breiten Schenkels 13 aufsteht (Fig. 2). Zugleich steht der schmale Schenkel 14 der Winkel-leiste 12 mit seiner Außenkante 18 auf der Außenseite 19 (siehe Fig. 1) des Deckbleches 4 bzw. des Bodenbleches 8 auf, wodurch eine scharfkantige Ecke erzielt wird.

Entlang der Längskante 16 der Abkantung 10 des Deckbleches 4 und des Bodenbleches 6 sowie entlang der Außenkante 18 des schmalen Schenkels 14 der Winkelleiste 12 sind Verbindungsmittel 20 vorgesehen.

Als Verbindungsmittel 20 steht entlang der Außenkante 18 des schmalen Schenkels 14 der Winkelleiste 12 eine Reihe von äquidistant angeordneten Zinken 21 hervor (vgl. Fig. 3 und 4), die in eine Reihe von Aufnahmen 22 im Deckblech 4 bzw. im Bodenblech 6 eingreifen. Entsprechend trägt die Abkantung 10 von Deckblech 4 und Bodenblech 6 eine zweite Reihe von Zinken 21, die in eine zweite Reihe von Aufnahmen 22 eingesteckt sind, die sich im breiten Schenkel 13 der Winkelleiste 12 befinden.

Die Reihen von Zinken 21 sind gegenüber den Reihen von Aufnahmen 22 in sich geringfügig, d.h. um Bruchteile eines Millimeters, gegeneinander versetzt angeordnet, wodurch eine Klemmverbindung beim Zusammenstecken von Winkelleiste 12 und Deckblech 4 bzw. Bodenblech 6 erzielt wird. Die Zinken 21 und die Aufnahmen 22 besitzen rechtwinkeligen Querschnitt und an den Köpfen der Zinken 21 sind Abschrägungen 23 als Einsteckhilfe vorgesehen. An die Stelle der Zinken 21 und Aufnahmen 22 kann ein geeigneter Kleber (nicht dargestellt) treten.

Der breite Schenkel 13 der Winkelleiste 12 bildet einen als Dach bezeichneten Überstand 24 (Fig. 1) in welchem äquidistant angeordnete Rechtecköffnungen 25 vorgesehen sind.

Sowohl das Deckblech 4 wie das Bodenblech 6 weisen an ihren Seitenrändern rechtwinklig hochstehende Laschen 26 auf (siehe Fig. 1 und 4), die mit Befestigungslöchern 27 versehen sind, welche mit Schraubenlöchern 28 an den Längsrändern der Seitenwände 2 und 3 fluchten.

Zwischen der Abkantung 10 des Deckbleches 4 und des Bodenbleches 6 einerseits und dem schmalen Schenkel 14 der Winkelleiste 12 andererseits ist ein Abstand 29 vorgesehen. Dadurch wird zwischen dem Deckblech 4 bzw. dem Bodenblech 6 und der Winkelleiste 12 ein geschlossener Kanal 30 mit etwa rechteckigem Querschnitt gebildet.

Das Bodenblech 6 und das Bodenteil 7 können - siehe Figuren 2 und 3 - einstückig gefertigt sein ; das gleiche gilt für das Deckblech 6 und das Deckenteil 7. Dabei weisen die Deckenteile 5 und die Bodenteile 7 an ihrer Hinterkante ebenfalls eine weitere Abkantung 31 auf, die Gewindelöcher 32 zur Befestigung von Steckverbindern und/oder Busplatinen trägt, welche an der Rückseite des Baugruppenträgers angeordnet sind.

Vier parallele Reihen von rechteckigen und kreisförmigen Löchern und Öffnungen 33 dienen zur Aufnahme der endständigen Befestigungsmittel der (nicht dargestellten) Führungsschienen.

### Zusammenstellung der Bezugszeichen

- 1: Baugruppenträger
- 2: Seitenwand
- 3: Seitenwand
- 4: Deckblech
- 5: Deckenteil
- 6: Bodenblech
- 7: Bodenteil
- 8: Kopfschrauben
- 9: Befestigungsflansche
- 10: Abkantung (von 4 und 6)
- 11: Löcher
- 12: Winkelleiste
- 13: Breiter Schenkel (von 12)
- 14: Schmaler Schenkel (von 12)
- 15: Gewindelöcher
- 16: Längskante
- 17: Innenseite (von 13)
- 18: Außenkante (von 14)
- 19: Außenseite (von 4 bzw. 6)
- 20: Verbindungsmittel
- 21: Zinken
- 22: Aufnahmen
- 23: Abschrägung
- 24: Überstand
- 25: Rechtecköffnungen
- 26: Laschen
- 27: Befestigungslöcher
- 28: Schraubenlöcher (in 2 und 3)
- 29: Abstand
- 30: Kanal
- 31: Abkantung
- 32: Gewindelöcher
- 33: Löcher und Öffnungen

## Patentansprüche

1. Baugruppenträger. mit
- zwei Seitenwänden
- wenigstens einem Deckblech
- wenigstens einem Bodenblech
- wobei das Deckblech und das Bodenblech zwischen den Seitenwänden befestigt sind,
- und das Deckblech und das Bodenblech eine rechtwinklig hochstehende Abkantung aufweist,
**gekennzeichnet durch** folgende Merkmale
- je eine Winkelleiste (12) ist am Deckblech (4) bzw. am Bodenblech (6) parallel zu der Abkantung (10) angesetzt,
- die Winkelleiste (12) besitzt einen breiten Schenkel (13) und einen rechtwinklig abgekanteten, schmalen Schenkel (14),
- der schmale Schenkel (14) trägt eine Reihe von Gewindelöchern (15),
- die Abkantung (10) steht mit ihrer Längskante (16) auf der Innenseite (17) des breiten Schenkels (13) auf,
- der schmale Schenkel (14) steht mit seiner Außenkante (18) auf der Außenseite (19) des Deckbleches (4) bzw. des Bodenbleches (6) auf,
- die Abkantung (10) weist eine Reihe von Löchern (11) auf, die mit den Gewindelöchern (15) fluchten,
- entlang der Längskante (16) der Abkantung (10) und der Außenkante (18) sind Verbindungsmittel (20) vorgesehen.

2. Baugruppenträger nach Anspruch 1, **dadurch gekennzeichnet, daß** das Deckblech (4), das Bodenblech (6) sowie die Winkelleiste (12) aus korrosionsgeschütztem Stahlblech gleicher Dicke bestehen.

3. Baugruppenträger nach Anspruch 1 oder 2, **dadurch gekennzeichnet, daß** wenigstens ein Teil der Löcher (11) als Paßlöcher ausgebildet sind.

4. Baugruppenträger nach einem der Ansprüche 1 bis 3, **dadurch gekennzeichnet, daß** der breite Schenkel (13) der Winkelleiste (12) einen vorstehenden Überstand (24) bildet, in welchem äquidistante Rechtecköffnungen (25) in Reihe vorgesehen sind.

5. Baugruppenträger nach einem der Ansprüche 1 bis 4, **dadurch gekennzeichnet, daß** als Verbindungsmittel (20) entlang der Außenkante (18) des schmalen Schenkels (14) eine erste Reihe von Zinken (21) hervorsteht, die in eine erste Reihe von Aufnahmen (22) in Deckblech (4) bzw. Bodenblech (6) eingreifen.

6. Baugruppenträger nach einem der Ansprüche 1 bis 5, **dadurch gekennzeichnet, daß** als Verbindungsmittel (20) entlang der Abkantung (10) des Deckbleches (4) und des Bodenbleches (6) eine zweite Reihe von Zinken (21) hervorsteht, die in eine zweite Reihe von Aufnahmen (22) im breiten Schenkel (13) der Winkelleiste (12) eingreifen.

7. Baugruppenträger nach einem der Ansprüche 1 bis 6, **dadurch gekennzeichnet, daß** die Reihe der Zinken (21) gegenüber der Reihe von Aufnahmen (22) jeweils geringfügig versetzt angeordnet ist.

8. Baugruppenträger nach einem der Ansprüche 1 bis 5, **dadurch gekennzeichnet, daß** als Verbindungsmittel (20) ein Kleber vorgesehen ist.

9. Baugruppenträger nach einem der Ansprüche 1 bis 8, **dadurch gekennzeichnet, daß** das Deckblech (4) und das Bodenblech (6) an ihren Seitenrändern rechtwinklig hochstehende Laschen (26) aufweisen, die mit Befestigungslöchern (27) versehen sind, welche mit Schraubenlöchern (28) an den Längsrändern der Seitenwände (2 und 3) fluchten.

10. Baugruppenträger nach einem der Ansprüche 1 bis 9, **dadurch gekennzeichnet, daß** das Deckblech (4) und das Bodenblech (6) identisch ausgebildet sind.

11. Baugruppenträger nach einem der Ansprüche 1 bis 10, **dadurch gekennzeichnet, daß** zwischen der Abkantung (10 und dem schmalen Schenkel (14) ein Abstand (29) vorgesehen ist, wodurch zwischen dem Deckblech (4) bzw. dem Bodenblech (6) und der Winkelleiste (12) ein geschlossener Kanal (30) von rechteckigem Querschnitt gebildet ist.

12. Baugruppenträger nach einem der Ansprüche 1 bis 11, **dadurch gekennzeichnet, daß** das Deckenteil (5) und das Bodenteil (7) an ihrer Hinterkante eine weitere Winkelleiste sowie eine Ausbildung ausweisen, welche mit derjenigen ihrer vorderen Stirnseite übereinstimmen.

13. Baugruppenträger nach einem der Ansprüche 1 bis 11, **dadurch gekennzeichnet, daß** das Deckblech (4) mit dem Deckenteil (5) und das Bodenblech (6) mit dem Bodenteil (7) einstückig gefertigt sind und Deckenteil (5) sowie Bodenteil (7) an ihrer hinteren Kante eine weitere Winkelleiste sowie eine Ausbildung auweisen, welche mit derjenigen der vorderen Stirnseite übereinstimmt.

## Claims

1. Subrack with
- two side walls
- at least one cover plate
- at least one bottom plate
- wherein the cover plate and the bottom plate are fastened between the side walls,
- and the cover plate and the bottom plate comprise a bent portion rising at a right angle,
**characterised by** the following features
- a respective angle strip (12) is attached to the cover plate (4) and the bottom plate (6) parallel to the bent portion (10),
- the angle strip (12) has a wide leg (13) and a narrow leg (14) which is bent at right angle,
- the narrow leg (14) bears row of threaded holes (15),
- the bent portion (10) stands with its longitudinal edge (16) on the inside (17) of the wide leg (13),
- the narrow leg (14) stands with its outer edge (18) on the outside (19) of the cover plate (4) or the bottom plate (6),
- the bent portion (10) comprises a row of holes (11) which are in alignment with the threaded holes (15),
- connection means (20) are provided along the longitudinal edge (16) of the bent portion (10) and the outer edge (18).

2. Subrack according to Claim , **characterised in that** the cover plate (4), the bottom plate (6) and the angle strip (12) consist of corrosion-resistant steel sheet of the same thickness.

3. Subrack according to Claim 1 or 2, **characterised in that** at least some of the holes (11) are formed as dowel holes.

4. Subrack according to any one of Claims 1 to 3,
**characterised in that** the wide leg (13) of the angle strip (12) forms a projection (24), in which equidistant rectangular openings (25) are provided in a row.

5. Subrack according to any one of Claims 1 to 4,
**characterised in that** a first row of teeth (21) protrude as connection means (20) along the outer edge (18) of the narrow leg (14), which teeth engage in a first row of receptacles (22) in the cover plate (4) or bottom plate (6).

6. Subrack according to any one of Claims 1 to 5,
**characterised in that** a second row of teeth (21) protrude as connection means (20) along the bent portion (10) of the cover plate (4) and the bottom plate (6), which teeth engage in a second row of receptacles (22) in the wide leg (13) of the angle strip (12).

7. Subrack according to any one of Claims 1 to 6,
**characterised in that** the row of tongues (21) is in each case staggered slightly with respect to the row of receptacles (22).

8. Subrack according to any one of Claims 1 to 5,
**characterised in that** an adhesive is provided as connection means (20).

9. Subrack according to any one of Claims 1 to 8,
**characterised in that** the cover plate (4) and the bottom plate (6) comprise at their side edges joint pieces (26) which rise at a right angle and which are provided with fastening holes (27) which are in alignment with screw holes (28) at the longitudinal edges of the side walls (2 and 3).

10. Subrack according to any one of Claims 1 to 9,
**characterised in that** the cover plate (4) and the bottom plate (6) are formed in an identical manner.

11. Subrack according to any one of Claims 1 to 10,
**characterised in that** there is a spacing (29) between the bent portion (10) and the narrow leg (14), whereby a closed duct (30) of a rectangular cross section is formed between the cover plate (4) or bottom plate (6) and the angle strip (12).

12. Subrack according to any one of Claims 1 to 11,
**characterised in that** the covering part (5) and the bottom part (7) comprise at their rear edge a further angle strip and a formation which corresponds to that of their front face.

13. Subrack according to any one of Claims 1 to 11,
**characterised in that** the cover plate (4) is integral with the covering part (5), and the bottom plate (6) is integral with the bottom part (7), and the covering part (5) and bottom part (7) comprise at their rear edge a further angle strip and a formation which corresponds to that of the front face.

## Revendications

1. Support de modules comportant
- deux parois latérales
- au moins une tôle de couvercle
- au moins une tôle de fond
- dans lequel la tôle de couvercle et la tôle de fond sont fixées entre les parois latérales,
- et la tôle de couvercle et la tôle de fond comportent un rebord vertical à angle droit,
**caractérisé par** les particularités suivantes
- une cornière (12) est montée respectivement sur la tôle de couvercle (4) et la tôle de fond (6) parallèlement au rebord (10),
- la cornière (12) possède un côté large (13) et un côté étroit (14) formant rebord à angle droit,
- le côté étroit (14) comporte une rangée de trous taraudés (15),
- le rebord (10) repose par son arête longitudinale (16) sur la face intérieure (17) du côté large (13),
- le côté étroit (14) repose par son arête extérieure (18) sur la face extérieure (19) de la tôle de couvercle (4) ou de la tôle de fond (6),
- le rebord (10) comporte une rangée de trous (11), qui coïncident avec les trous taraudés (15),
- des moyens d'assemblage (20) sont prévus le long de l'arête longitudinale (16) du rebord (10) et de l'arête extérieure (18).

2. Support de modules selon la revendication 1, **caractérisé en ce que** la tôle de couvercle (4), la tôle de fond (6) ainsi que la cornière (12) sont constituées de tôle d'acier protégée contre la corrosion, de même épaisseur.

3. Support de modules selon la revendication 1 ou 2, **caractérisé en ce qu'**au moins une partie des trous (11) sont constitués en passages.

4. Support de modules selon l'une des revendications 1 à 3, **caractérisé en ce que** le côté large (13) de la cornière (12) forme un rebord saillant (24), dans lequel sont prévues, en rang, des ouvertures carrées (25) équidistantes.

5. Support de modules selon l'une des revendications 1 à 4, **caractérisé en ce qu'**en tant que moyens d'assemblage (20) une première rangée d'ergots (21), qui viennent en prise dans une première rangée de logements (22) dans la tôle de couvercle (4) ou la tôle de fond (6), fait saillie le long de l'arête extérieure (18) du côté étroit (14).

6. Support de modules selon 'une des revendications 1 à 5, **caractérisé en ce qu'**en tant que moyens d'assemblage (20) une seconde rangée d'ergots (21), qui viennent en prise dans une seconde rangée de logements (22) dans le côté large (13) de la cornière (12), fait saillie le long du rebord (10) de la tôle de couvercle (4) et de la tôle de fond (6).

7. Support de modules selon 'une des revendications 1 à 6, **caractérisé en ce que** la rangée des ergots (21) est respectivement disposée légèrement décalée en regard de la rangée de logements (22).

8. Support de modules selon 'une des revendications 1 à 5, **caractérisé en ce qu'**un adhésif est prévu en tant que moyen d'assemblage (20).

9. Support de modules selon 'une des revendications 1 à 8, **caractérisé en ce que** la tôle de couvercle (4) et la tôle formant fond (6) comportent sur leurs bords latéraux des pattes (26) verticales à angle droit, qui sont pourvues de trous de fixation (27), lesquels coïncident avec les trous taraudés (28) sur les bords longitudinaux des parois latérales (2 et 3).

10. Support de modules selon l'une des revendications 1 à 9, **caractérisé en ce que** la tôle de couvercle (4) et la tôle de fond (6) sont de configuration identique.

11. Support de modules selon l'une des revendications 1 à 10, **caractérisé en ce qu'**entre le rebord (10) et le côté étroit (14) est prévu un écartement (29) par lequel un canal fermé (30) de section carrée est formé entre respectivement la tôle de couvercle (4) et la tôle de fond (6) et la cornière (12).

12. Support de modules selon l'une des revendications 1 à 11, **caractérisé en ce que** a pièce de couvercle (5) et la pièce de fond (7) comportent à leur arête arrière une autre cornière et une configuration qui correspondent à celles de leur face avant.

13. Support de modules selon l'une des revendications 1 à 11, **caractérisé en ce que** sont réalisés d'un seul tenant la tôle de couvercle (4) avec la pièce de couvercle (5) et la tôle de fond (6) avec la pièce de fond (7), et la pièce de couvercle (5) ainsi que la pièce de fond (7) présentent à leur arête arrière une autre cornière ainsi qu'une configuration qui correspond à celles de la face avant.
